Europäisches Patentamt

**European Patent Office**

**Office européen des brevets**

(11) Numéro de publication: **0 169 136**
A1

## (12) DEMANDE DE BREVET EUROPEEN

(21) Numéro de dépôt: **85401367.9**

(22) Date de dépôt: **05.07.85**

(51) Int. Cl.⁴: **H 05 K 7/20**

(30) Priorité: **06.07.84 FR 8410734**

(43) Date de publication de la demande: **22.01.86**
**Bulletin 86/4**

(84) Etats contractants désignés: **BE DE NL SE**

(71) Demandeur: **R.V. Electronique, Société Anonyme dite:,**
**Z.I. Les Carreaux, F-77440 Lizy-sur-Ourq (FR)**

(72) Inventeur: **Vulpillat, Roland, 25 allée Valère-Lefèbvre,**
**F-93340 Le Raincy (FR)**

(74) Mandataire: **Dupuy, René Gaston, Cabinet René G.**
**Dupuy & Jean M.L. Loyer 14, Rue La Fayette,**
**F-75009 Paris (FR)**

(54) **Gradateur enfichable perfectionné.**

(57) Gradateur enfichable perfectionné, caractérisé par le fait qu'il comporte, à titre de châssis principal, une âme-support (1) constituée par un radiateur-dissipateur à ailettes (2), de profil spécial monobloc, obtenu par filage d'un matériau tel que l'aluminium, ledit profilé étant, en outre, muni de parties, surfaces, redans, ergots, prolongements, retours, butées, nervures, rainures, appropriés afin de recevoir, pour y être fixés, les différents éléments composant habituellement un gradateur, deux de ces prolongements relativement importants étant conformés pour constituer, l'un, une poignée ergonomique (19), avantageusement située dans un plan parallèle à la face avant du gradateur, l'autre, un cache de protection (3) pouvant être assimilé à la face avant du gradateur, et empêchant toute accessibilité directe aux composants du gradateur, l'extrémité de ce cache-face avant étant conçue (5, 6) pour recevoir simultanément la carte imprimée principale (8) du gradateur ainsi qu'une plaque isolante de protection (7) de ladite carte.

0169136

- 1 -

GRADATEUR ENFICHABLE PERFECTIONNE

La présente invention concerne la constitution des appareils dénommés "Gradateurs" que l'on utilise dans les installations permettant de faire varier l'intensité lumineuse dans des locaux à destinations multiples.

Ces appareils bien connus sont généralement montés dans des armoires contenant une pluralité d'appareils de commande et de contrôle électriques ou électroniques avantageusement disposés, par exemple, en rayons horizontaux et étages superposés.

Chaque gradateur constitue un ensemble monobloc composite recevant une pluralité de composants, cet ensemble présentant habituellement sur sa face avant une poignée de préhension et de transport, et sur sa face arrière, des broches de liaison électrique enfichables. La connection de l'ensemble se fait alors par introduction et coulissement horizontal dans une glissière appropriée. C'est la fonction bien connue du "rack" qui remplit son rôle après introduction à fond de course du "tiroir".

Les appareils classiques et traditionnels présentent cependant des inconvénients notoires dus au fait que le gradateur est un ensemble hétérogène rassemblant autour d'un châssis des éléments aussi divers que : -semi-conducteurs de puissance, -condensateur d'antiparasitage, -selfs de filtrage, -broches d'enfichage, -circuit imprimé électronique et ses composants, -radiateur-dissipateur de refroidissement, -poignée avant de support et de manoeuvre, et autre éléments d'habillage ou de liaison.

Les inconvénients en question peuvent être énumérés comme suit :

- défaut d'homogénéité de l'ensemble ;
- manipulations assez peu pratique dans leurs réalisations actuelles ;
- composants non protégés sur l'accessibilité avant ;
- poignées désuètes, parfois agressives et peu commodes ;

    - radiateurs non optimisés donc d'efficacité moyenne ;

    - présentation non rationnelle (peu abritée contre les chocs) ;

    - circuit imprimé non protégé contre les accès de manipulation et de transport ;

    - compacité (rapport volume/performance criticable) surtout pour le matériel mobile.

On précisera, avant d'exposer l'invention, que l'on connaît déjà l'utilisation dans les gradateurs, de radiateurs-dissipateurs à ailettes de refroidissement, utilisant un principe bien connu dans de multiples domaines techniques où les ailettes augmentent de façon notable la surface de dissipation des calories.

L'invention part précisément de l'étude d'un profilé spécial qui va constituer l'élément technologique central du gradateur perfectionné, objet de la présente demande de brevet.

Alors que dans les gradateurs connus, le radiateur-dissipateur est un élément composant qui est un accessoire au même titre que les autres, dans le gradateur conforme à l'invention, le radiateur-dissipateur à ailettes devient l'élément principal autour duquel tout est créé, monté, assemblé. Il n'est alors plus l'accessoire du gradateur, mais son élément structurel essentiel.

L'idée inventive repose sur la conception d'un profilé spécial de radiateur-dissipateur auquel on attribue des rôles multiples, imprévus, et originaux dans leur ensemble, et pour lesquels un tel élément n'avait jamais été prévu jusqu'à présent.

En effet, ce profilé spécial devenu élément essentiel du gradateur, va permettre de résoudre simultanément les problèmes et fonctions ci-après.

    - Radiation-dissipation optimisée de la chaleur, créée par le fonctionnement normal du produit, bien entendu.

- Structure architecturale de base autour de laquelle tout est monté et assemblé, avec les avantages de rigidité, de robustesse, de cohésion et d'unité qui en résultent.

- Allègement de l'ensemble puisqu'on supprime plusieurs pièces dont un châssis-support, le profilé spécial en tenant lieu lui-même.

- Protection de la face avant du gradateur grâce à une paroi en retour faisant office de cache, paroi venue de filage en même temps que le corps du radiateur.

- Constitution d'une poignée monobloc, également venue de filage en même temps que le corps du radiateur.

- Prévision dans le retour de la face protectrice avant, d'une bande réceptrice et de maintien de la plaque-support constituant la carte imprimée, ainsi que d'une plaquette isolante protégeant de tout contact, éraflure ou arrachement extérieur, la face externe de la carte imprimée.

En conséquence, la conception et les dispositions de ce nouveau profilé de radiateur-dissipateur, permettent de rassembler en une seule pièce, les fonctions qui, antérieurement étaient assurées par au moins trois pièces distinctes.

La définition de l'invention peut donc, en résumé, être donnée de la manière suivante :

- gradateur enfichable perfectionné caractérisé par le fait qu'il comporte, à titre de châssis principal, une âme-support constituée par un radiateur-dissipateur à ailettes, de profil spécial monobloc, obtenu par filage d'un matériau tel que l'aluminium ultérieurement oxydé, ledit profilé étant, en outre, muni de parties, surfaces, redans, ergots, prolongements, retours, butées, nervures, rainures, appropriés et spécialement étudiés, afin de recevoir, pour y être fixés, les différents éléments composant habituellement un gradateur, deux de ces prolongements relativement

- 4 -

importants étant conformés pour constituer, l'un, une poignée ergonomique avantageusement située dans un plan parallèle à la face avant du gradateur, l'autre, un cache de protection pouvant être assimilé à la face avant du gradateur, et empêchant toute accessibilité directe aux composants du gradateur, l'extrémité de ce cache-face avant étant conçue pour recevoir simultanément la carte imprimée principale du gradateur ainsi qu'une plaque isolante de protection de ladite carte.

D'autres particularités et avantages apparaîtront au cours de la description qui va suivre, faite en regard des dessins annexés donnés à titre d'exemples non limitatifs.

- *la figure 1* est une vue en perspective d'un gradateur perfectionné conforme à l'invention ;

- *la figure 2* est une vue de dessus montrant le même gradateur pourvu seulement de certains de ses composants ;

- *la figure 3* est une vue de dessus montrant la juxtaposition horizontale de deux profils permettant la constitution d'un gradateur de puissance supérieure en bénéficiant de toutes les données relatives à l'invention.

Dans le mode de réalisation représenté au dessin annexé, on voit en 1 le corps principal du radiateur-dissipateur pourvu d'ailettes de refroidissement 2, disposées verticalement dans le sens naturel de la ventilation. Il est monobloc et venu de filage, par exemple en aluminium et oxydé après filage. Sa longueur est prévue en fonction des dimensions du gradateur à constituer, et il est conformé en fonction des composants à recevoir.

A l'avant, le radiateur 1 est pourvu d'une face 3 dont la partie apparente comporte des nervures, rainures et striures appropriées, délimitant des zones verticales d'enjolivement, de protection contre les éraflures, ou de réception d'étiquettes d'identification.

Le rôle essentiel de cette face avant 3, dont on remarquera que la largeur est égale à celle du gradateur

0169136

- 5 -

lui-même, est d'empêcher tout accès direct aux composants fixés sur le gradateur (protection contre leur destruction et protection de personnes contre l'accès à des pièces sous tension).

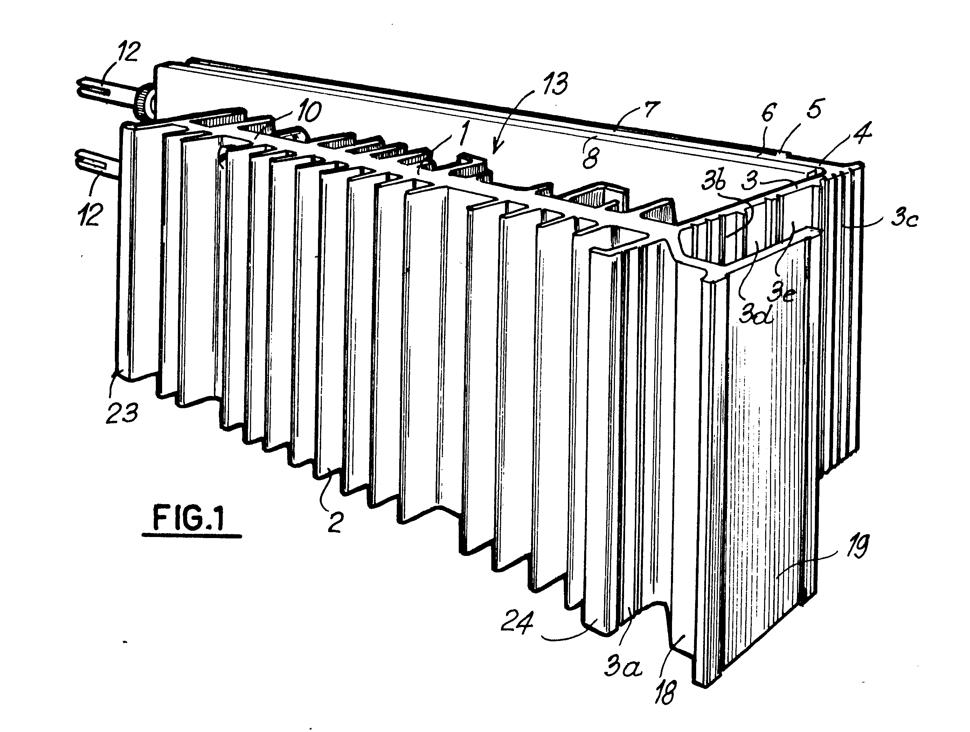

Les zones 3a, 3b, 3c seront avantageusement des zones striées (bandes verticales fig. 1) tandis que les zones 3d, 3c seront des zones plates, par exemple destinées à recevoir des étiquettes.

A l'extrémité droite de la face avant 3 est prévue une paroi en retour perpendiculaire 4 terminée par un bossage 5 comportant, ouverte vers l'arrière, une rainure 6. Cette rainure 6 joue un rôle important car elle est destinée à recevoir le rebord vertical avant d'une contre-carte ou plaque isolante 7 de protection des composants et parties électriques portés par la carte imprimée 8 portant les composants de puissance.

La carte 8 accolée contre la plaque isolante 7 est ainsi protégée contre toute accessibilité par la droite du gradateur.

La fixation de l'ensemble 7-8 par rapport au corps 1 du dissipateur se fait par une entretoise 9 qui assure la liaison mécanique, donc la rigidité, entre l'ensemble 7-8 et une zone 10 du corps 1 située dans une partie surépaissie afin d'améliorer les caractéristiques de conductivité thermique. C'est précisément sur cette entretoise qu'est monté le semi-conducteur de puissance 11.

On voit à l'extrémité arrière de l'ensemble 7-8, les broches de connection 12, situées aux mêmes endroits que celles des gradateurs antérieurement commercialisés, ce qui les rend par conséquent interchangeables. Les dimensions hors-tout et les aménagements sont tels que les nouveaux gradateurs sont mécaniquement et électriquement interchangeables avec ces appareils analogues antérieurs.

Entre le dissipateur 1 et l'ensemble 7-8, on dispose donc d'un volume disponible 13 pour le logement des divers com-

0169136

- 6 -

posants de puissance d'un gradateur traditionnel. On a déjà vu qu'on pouvait loger le semi-conducteur de puissance 11. On voit de plus en 14 une ou plusieurs selfs de filtrage fixées sur l'ensemble 7-8. Les divers composants peuvent donc être fixés soit sur le corps 1, soit sur l'ensemble 7-8.

Selon une particularité de l'invention, deux ailettes internes 15 et 16 peuvent être pourvues d'ergots 15a, 16a pour recevoir par clipsage (15b, 16b) la carte 17 d'un circuit imprimé de commande.

Selon une autre particularité importante de l'invention, on voit en 18, venue de filage avec le corps 1, une paroi de liaison convenablement conformée, terminée à l'avant par une poignée ergonomique 19 dont la face verticale avant peut être plane, afin de recevoir toutes indications imprimées, fiches ou étiquettes de repérage et d'identification.

Cette poignée est étudiée pour qu'elle se situe parallèlement à une distance convenable de la paroi 3.

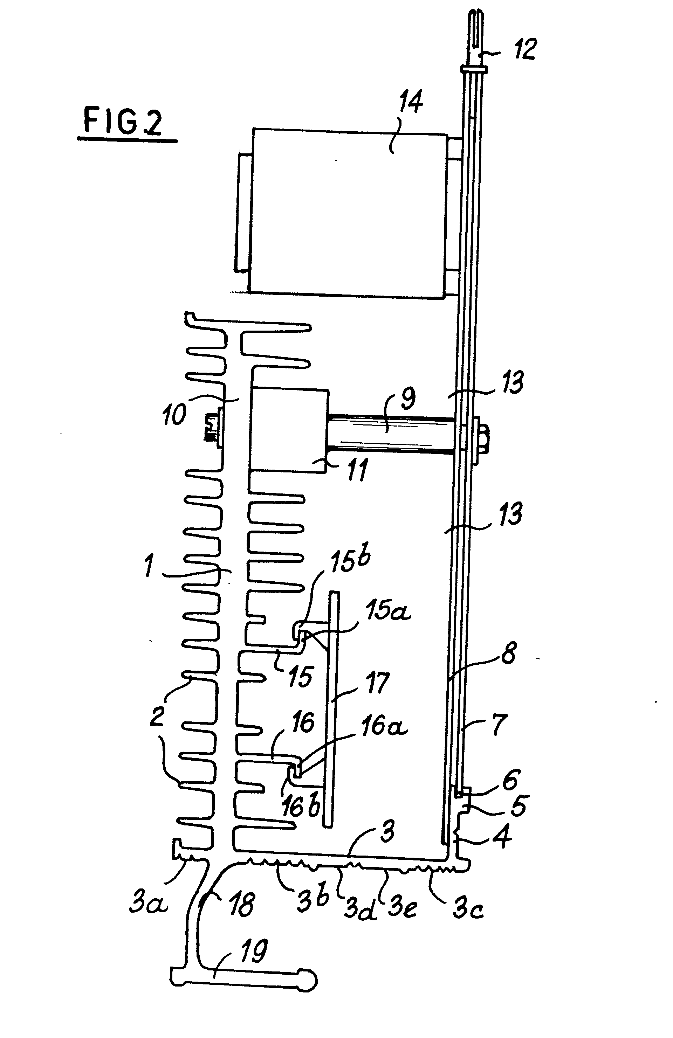

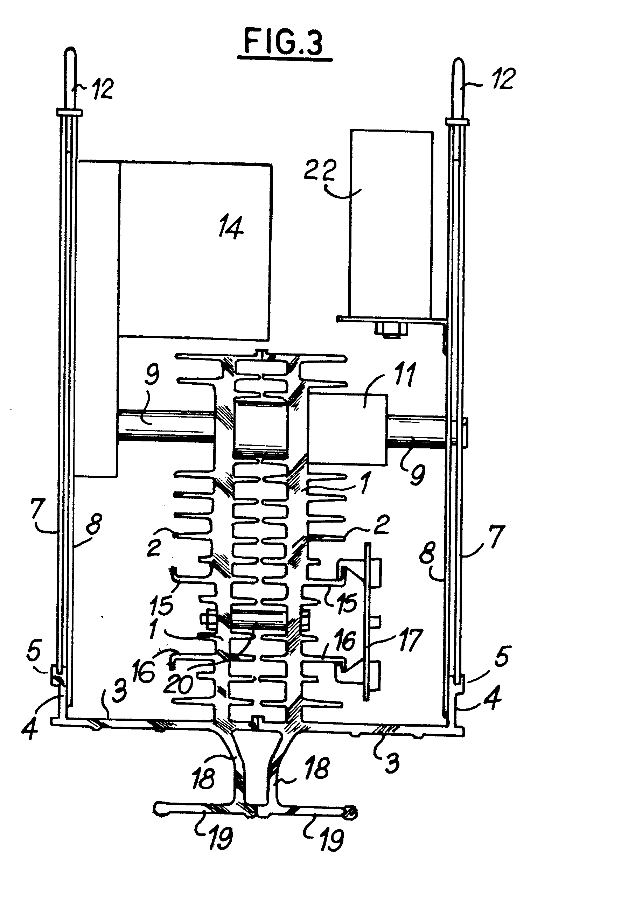

Dans le mode de réalisation de la figure 3, on voit qu'on a accolé horizontalement et symétriquement deux profils tels que celui des figures 1 et 2, afin de constituer un gradateur plus puissant.

L'assemblage a lieu à deux niveaux : par la continuité axiale des deux entretoises 9 déjà décrites, et par une entretoise complémentaire 20, avec mise en appui mécanique par deux retours plans 23, les ailettes 2 étant en retrait léger afin d'éviter que d'éventuelles vibrations ne provoquent un bruit.

Axialement aux entretoises 9, et entre les deux corps 1 est prévu un bloc de jonction mécanique et thermique 21.

Enfin, on voit en 22 sur la carte de droite un condensateur d'antiparasitage important, non représenté aux figures 1 et 2.

L'ensemble de la figure 3 constitue donc en double largeur, un gradateur de puissance possible égale au double de celle d'un gradateur des figures 1 et 2.

Les avantages du gradateur conforme à l'invention, qui vient d'être décrit, ressortent maintenant à l'évidence.

On énumérera ci-après, de manière non limitative, les avantages dudit gradateur :

- Il incorpore une partie plane 3 située à l'avant (derrière la poignée 19) qui protège tous les composants électroniques contre un accès direct ce qui évite d'une part une destruction involontaire et d'autre part, évite à tous manipulateurs d'être en contact avec des pièces sous tension.

- La poignée de forme ergonomique 19 est solidement intégrée au profil, ce qui lui permet de recevoir tous les efforts d'enfichage et de désenfichage sans avoir à subir des contraintes mécaniques excessives.

- La nervure 18 de liaison de la partie située entre la partie avant de la poignée et la face avant, a une forme qui lui permet de donner une robustesse très grande contre des chocs éventuels auxquels peuvent être soumis l'ensemble de l'appareil soit au moment des transports, soit au moment des utilisations en enfichage et désenfichage.

- Les parties réservées aux étiquettes 3d, 3e sont légèrement en retrait de telle façon que tous frottements s'effectuent sur les parties en protubérance protégeant ainsi les étiquettes de rayures ou d'arrachement.

- Les parties striées dans le sens vertical 3a, 3b, 3c sont telles que le produit garde un bel aspect même après des manipulations et des chocs multiples.

- La partie destinée à recevoir la carte imprimée 8 comporte également une rainure d'encastrement 6 pour une plaque isolante de protection 7 située parallèlement aux parties conductrices du circuit imprimé et permet ainsi la protection contre des destructions liées à des chocs extérieurs au moment de la manipulation et au moment des enfichages et des désenfichages.

- La partie principale portant des ailettes de refroidissement se trouve surépaissie au droit des points de fixation des semi-conducteurs de puissance 11 de telle façon que la conduction thermique en soit améliorée.

- Deux des ailettes 15, 16 ont été façonnées en forme d'Oméga aux dimensions du rail Din symétriques de façon à pouvoir recevoir tout composant électrique ou électronique pourvu d'un système de clipsage pour ce type de rail.

De cette façon il est inutile de prévoir pour lesdits composants une fixation par vis ou par d'autres moyens plus onéreux.

- Cette fixation par rail Din sera particulièrement retenue pour le maintien d'une carte imprimée auxiliaire telle que circuit de commande 17 associée ou non avec d'autres éléments tels que voyants (potentiomètre auxiliaire).

L'utilisation avantageuse de ce profilé permet d'avoir des éléments Gradateurs/Variateurs d'une puissance comprise entre 1 et 5 kw par unité enfichable et l'utilisation de deux profils placés dos à dos et maintenus par la fixation appropriée se situant au niveau des semi-conducteurs de puissance, permet de faire des Gradateurs-Variateurs de puissance supérieure à 5 kw et ceci jusqu'à 10 kw en ayant les mêmes dimensions en hauteur et en profondeur, seule l'épaisseur modulaire en face avant se trouve doublée.

Dans ce cas la poignée devient également symétrique et permet par sa fonction d'assurer naturellement l'enfichage, le défichage et le transport d'un appareil forcément plus lourd que l'unité simple.

La disposition avantageuse et la conception de ce profilé permettent donc de rassembler en une seule pièce

- 9 -

les fonctions qui préalablement sur les appareils de génération antérieure étaient assurées par deux ou trois pièces.

Il va de soi que l'on peut, sans sortir du cadre de la présente invention, apporter toutes modifications aux formes de réalisation qui viennent d'être décrites.

REVENDICATIONS

1.- Gradateur enfichable perfectionné *caractérisé* par le fait qu'il comporte, à titre de châssis principal, une âme-support (1) constitué par un radiateur-dissipateur à ailettes (2), de profil spécial monobloc, obtenu par filage d'un matériau tel que l'aluminium subissant ultérieurement un traitement d'oxydation, ledit profilé étant, en outre, muni de parties, surfaces, redans, ergots, prolongements, retours, butées, nervures, rainures, appropriés afin de recevoir, pour y être fixés ou appuyés, les différents éléments composant habituellement un gradateur, deux de ces prolongements relativement importants étant conformés pour constituer, l'un, une poignée ergonomique (19) avantageusement située dans un plan parallèle à la face avant du gradateur, l'autre, un cache de protection (3) pouvant être assimilé à la face avant du gradateur, et empêchant toute accessibilité directe aux composants du gradateur, l'extrémité de ce cache-face avant étant conçue (5, 6) pour recevoir simultanément la carte imprimée principale (8) du gradateur ainsi qu'une plaque isolante de protection (7) de ladite carte.

2.- Gradateur selon la revendication 1, *caractérisé* par le fait qu'entre le corps (1) et l'ensemble (7-8) est prévu un volume disponible (13) pour le logement des composants de puissance d'un gradateur traditionnel.

3.- Gradateur selon la revendication 1, *caractérisé* par le fait qu'il est prévu deux ailettes (15, 16) pourvues d'ergots (15a, 16a) destinés à recevoir par clipsage (15b, 16b) une carte (17) de circuit imprimé de commande.

4.- Gradateur de forte puissance *caractérisé* par le fait qu'il comporte l'assemblage horizontal de deux longueurs de profil selon la revendication 1.

5.- Gradateur selon la revendication 1, *caractérisé* par le fait que la partie principale portant des ailettes de refroidissement se trouve surépaissie au droit des

0169136

- 11 -

points de fixation des semi-conducteurs de puissance (11)
de telle façon que la conduction thermique en soit améliorée.

FIG.1

0169136

FIG 2

# FIG.3

Office européen des brevets

**RAPPORT DE RECHERCHE EUROPEENNE**

0169136

Numéro de la demande

EP 85 40 1367

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | DE-A-3 219 571 (FESTO MASCHINENFABRIK) <br> * Page 5, alinéa 3 - page 7, alinéa 1; page 8, alinéa 2 - page 9, alinéa 1; page 12, alinéa 3 - page 13, alinéa 2 * | 1 | H 05 K 7/20 |
| A | US-A-3 909 679 (R.E. PETRI) <br> * En entier * | | |
| A | DE-A-1 928 270 (BROWN, BOVERI) <br> * En entier * | | |

DOMAINES TECHNIQUES RECHERCHES (Int. Cl.4)

H 05 K
H 02 M

Le présent rapport de recherche a été établi pour toutes les revendications

| Lieu de la recherche | Date d'achèvement de la recherche | Examinateur |
|---|---|---|
| LA HAYE | 07-10-1985 | SCHRIJVERS H.J. |

OEB Form 1503 03.82